# EUROPEAN PATENT APPLICATION

(11) **EP 1 978 576 A2**
(43) Date of publication of application: **08.10.2008**
(21) Application number: 08251286.4
(22) Date of filing: 02.04.2008
(51) Int. Cl.: H01L 51/54

(54) **Organic light-emitting diode element and optical interconnection module**

(30) Priority: 03.04.2007 JP 2007097300; 01.04.2008 JP 2008095314
(71) Applicant: Fujikura, Ltd., Tokyo (JP); Shinshu University, Matsumoto-shi, Nagano-ken (JP)
(72) Inventor: Fukuda, Takeshi, Sakura-shi Chiba-ken (JP); Taniguchi, Yoshio, Ueda-shi Nagano-ken (JP)
(74) Representative: Walker, Edmund Mortimer

(57) **Abstract**

An organic light-emitting diode element (OLED element (1)) is provided. The OLED element (1) includes at least an anode (3), an emitting layer (5), an electron transport layer (6), a cathode (8) and an inorganic semiconductor material is used in the electron transport layer. An optical interconnection module is provided that uses the organic light-emitting diode element.

## Description

Apparatuses consistent with the present invention relate to a luminescence element using organic light-emitting diode (hereinafter referred to as "OLED"), and more particularly to an organic light-emitting diode element (hereinafter, referred to as "OLED element") and an optical interconnection module using the OLED element.

The OLED element generally has a structure in which a first electrode layer (anode), several organic layers, and a second electrode layer (cathode) are deposited on a surface of a transparent glass substrate or a transparent resin substrate. The OLED element has a characteristic of a high-contrast ratio, a wide viewing angle, and thinness. The OLED element has been applied to a display field. However, in a display using the OLED element, a typical element structure forming a light-emitting portion on a driving transistor circuit has a problem in that light emitted from the transistor portion is absorbed or diffused, and thus a reduction in luminous efficiency is caused. In order to solve such a problem, a structure called a top emission structure, in which a cathode, organic layers, and an anode are sequentially deposited on a glass substrate, has been studied.

The first electrode layer (anode) is formed of a transparent conductive material represented by indium tin oxide (ITO) or indium zinc oxide (IZO). The organic layers are formed of a plurality of layers which are constituted by a hole injection layer, a hole transport layer, an emitting layer, an electron transport layer, an electron injection layer, and the like.

The OLED element has been so far studied by many research institutes, and thus luminous characteristics (luminous efficiency, maximum luminance, power consumption, etc.) thereof have been considerably improved. For example, a phosphorescence material having luminous efficiency higher than a previous fluorescence material, a cathode material having a low work function, balance optimization of carriers of electrons and holes in the emitting layer have been studied. Moreover, as a manufacturing method of realizing low cost, in addition to a known vacuum deposition, processes which do not need vacuum state, such as screen printing, gravure printing, or ink jet printing, has been studied.

The optical interconnection module has a structure in which a light-emitting element and a light-receiving element are mounted in both ends of an optical fiber or a polymer optical waveguide. In the optical interconnection module, electrical signals are converted into optical signals by using the light-emitting element and the optical signals are sent to the light-receiving element through the polymer optical waveguide. In addition, the light-receiving element converts the optical signals into the electrical signals to perform communication.

Examples of optical interconnection modules using the OLED element include Japanese Unexamined Patent Application, Publication No. 2003-149541 and Japanese Unexamined Patent Application, Publication No. 2003-14995.

The OLED element can be used as the light-emitting element for transmitting light to an optical fiber or a polymer optical waveguide. Moreover, by using a deposition method, the OLED element can be directly formed even on a substrate on which the polymer optical waveguide having unfavorable thermal resistance is formed. Consequently, there is an advantage in that a complex optical axis does not need to be adjusted or the end surface of the optical waveguide does not need to be processed, and the optical waveguide and the OLED element can be simply coupled. Furthermore, the optical waveguide and the OLED element can be incorporated monolithically so as to be formed integrally. Therefore, a mounting process of the optical interconnection module can be considerably simplified at low costs.

Examples of techniques for improving a respond time of the OLED element include Japanese Unexamined Patent Application, Publication No. H5-29080, Japanese Unexamined Patent Application, Publication No. 2003-243157, and Japanese Unexamined Patent Application, Publication No. 2002-313553.

Japanese Unexamined Patent Application, Publication No. H5-29080 discloses a method, in which it is possible to improve the response time of the OLED element by reducing electrostatic capacitance of the OLED element. Japanese Unexamined Patent Application, Publication No. 2003-243157 discloses a rapid response time of 100 MHz by applying a voltage made by superimposing a bias voltage and a pulse voltage. In Japanese Unexamined Patent Application, Publication No. 2002-313553 the response time is improved by providing a hole blocking layer or an electron injection layer next to an emitting layer.

Examples of techniques for improving luminous efficiency of the OLED element are disclosed in Japanese Unexamined Patent Application, Publication No. H11-354283 and in Japanese Unexamined Patent Application, Publication No. 2000-164363. For example, a method of providing an inorganic compound in an interface between an organic layer and a cathode, and a method of interfusing the inorganic compound layer into an organic compound layer in the vicinity of a cathode are disclosed. The inorganic compound may be at least one selected from alkali metal oxides, rare earth metal halides, and alkali metal complex. Moreover, the inorganic compound may be formed in a layer shape or an island shape. In the case of the layer shape, the inorganic compound may be formed of electron-injecting alkali earth metal oxides, alkali oxides, or alkali fluorides, and the film thickness thereof is in the range from about 0.4 nm to 10 nm so as to form a super-thin film. Examples of alkali earth metal oxides include BaO, SrO, CaO, and BaₓSr₁₋ₓO (0<x<1) or BaₓCa₁₋ₓO (0<x<1) combined therewith. Examples of alkali oxides and alkali fluorides include LiF, Li₂O, and NaF. As a method of forming alkali earth metal oxides, a method of introducing oxygen into a vacuum tank may be used to set a vacuum degree in the range from 10⁻³ Pa to 10⁻⁴ Pa while depositing alkali earth metal by means of resistance-heating deposition, and reacting oxygen and alkali earth metal to perform deposition. Moreover, a method of forming a film with alkali earth metal oxides by means of electron beam evaporation may be used. As a method of forming alkali oxide, the same method as that of forming alkali earth metal oxides described above can be used. Examples of a method of forming alkali fluorides include the electron beam evaporation and the resistance-heating deposition.

As disclosed in Japanese Unexamined Patent Application, Publication No. 2002-164178 and Japanese Unexamined Patent Application, Publication No. 2003-238534, it is possible to improve element characteristics by containing the inorganic compound in the electron injection layer. The inorganic compound may be an insulator or a semiconductor. It is possible to efficiently prevent leakage of current and improve electron transport ability by containing the insulator and the semiconductor in the electron transport layer. The insulator contained in the electron transport layer may be at least one metal compound selected from a group consisting of alkali metal chalcogenides, alkali earth metal chalcogenides, alkali metal halides, and alkali earth metal halides. If the electron transport layer contains the alkali metal chalcogenides, etc., the electron transport ability can be further improved. Examples of alkali metal chalcogenides include Li₂O, LiO, Na₂S, Na₂Se, and NaO. Examples of alkali earth metal chalcogenides include CaO, BaO, SrO, BeO, BaS, and CaSe. Examples of alkali metal halides include LiF, NaF, KF, LiCl, KCI, and NaCl. Examples of alkali earth metal halides include fluoride such as CaF₂, BaF₂, SrF₂, MgF₂, and BeF₂ and halide in addition to fluoride. A semiconductor material which is able to be included in the electron transport layer is exemplified by oxides, nitride, or nitrided oxide containing at least one element among Ba, Ca, Sr, Yb, Al, Ga, In, Li, Na, Cd, Mg, Si, Ta, Sb, and Zn. These may be either used singly or in combination of two or more kinds.

However, the above-described techniques have the following disadvantages.

Japanese Unexamined Patent Application, Publication No. H5-29080, Japanese Unexamined Patent Application, Publication No. 2003-243157, and Japanese Unexamined Patent Application, Publication No. 2002-313553 disclose methods of improving the response time of the OLED element. However, the response time of the disclosed OLED element is not as rapid so as to be commercially used as the optical interconnection module. A practical response time is 100 MHz or more as a cutoff frequency, but the disclosed method just realizes the response time in the range from 10 MHz to 20 MHz at most.

As disclosed in Japanese Unexamined Patent Application, Publication No. H11-354283 and Japanese Unexamined Patent Application, Publication No. 2000-164363, the response time of the OLED element is slightly improved by inserting an inorganic compound layer in the interface between the organic layer and the cathode. However, since the organic compound is used in the electron transport layer and an organic material has low electron mobility, the improvement in the response time of the OLED element is restrictive.

An exemplary object of the invention is to provide an OLED element capable of improving a response time and an optical interconnection module using the OLED element.

According to an exemplary aspect of the invention, there is an organic light-emitting diode element at least including: an anode, an emitting layer, an electron transport layer, and a cathode, wherein a semiconductor material is used in the electron transport layer.

In an organic light-emitting diode element according to such a configuration, the semiconductor material used in the electron transport layer may be a Groups II-VI compound semiconductor.

In an organic light-emitting diode element according to such a configuration, the semiconductor material of the Group 11-VI compound semiconductor may be ZnS.

In an organic light-emitting diode element according to such a configuration, the thickness of the electron transport layer formed of ZnS may be in the range from 10 nm to 300 nm.

In an organic light-emitting diode element according to such a configuration, the semiconductor material used in the electron transport layer may contain a reducing dopant.

In an organic light-emitting diode element according to such a configuration, the reducing dopant may have a work function of 2.9 eV or less.

Moreover, the reducing dopant may be at least one kind selected from a group consisting of alkali metals, alkali earth metals, rare earth metals, alkali metal oxides, alkali metal halides, alkali earth metal oxides, alkali earth metal halides, oxides of rare earth atoms, and rare earth metal halides.

According to another exemplary aspect of the invention, there is an optical interconnection module which uses the organic light-emitting diode element according to the above-described configuration as a light source for transmission.

An exemplary OLED element according to the invention can improve a response time of the OLED element by using a light-emitting material with high electron mobility in the electron transport layer.

### IN THE DRAWINGS:

FIG. 1 is a sectional view illustrating an OLED element according to an exemplary embodiment of the invention.
FIG. 2 is a graph showing frequency dependency of an output light intensity in Example 1 and Comparative Example 1.

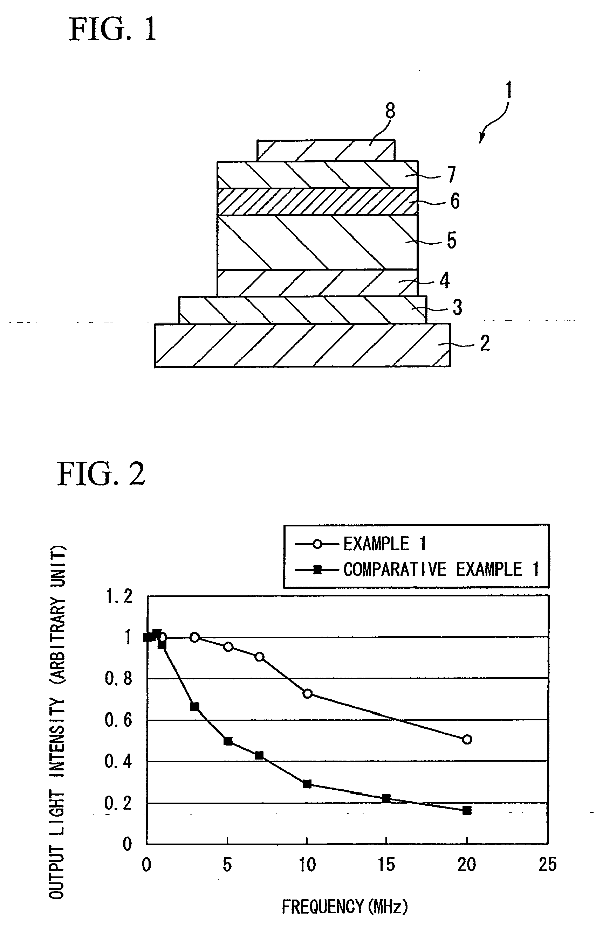

FIG. 1 is a cross-sectional view illustrating an OLED element according to an embodiment of the invention. An OLED element 1 according to the embodiment has a structure in which an anode 3 formed of an ITO thin film, a hole transport layer 4, an emitting layer 5, an electron transport layer 6 made of an inorganic material such as ZnS, an electron injection layer 7, and a cathode 8 formed of a metal thin film are sequentially deposited on a substrate 2 made of a transparent material such as glass. In the OLED element 1 according to the embodiment, an inorganic material, particularly, a semiconductor material such as ZnS is used in the electron transport layer 6, which has the function of transporting electrons.

In the OLED element, electrons injected into the inside of the organic layer from the cathode are recombined with holes in the emitting layer to radiate. That is, a response time of the OLED element depends on the period of time during which electrons are injected into the cathode and recombined. The time during which the electrons move inside the electron transport layer occupies most of this period of time, and this time is evaluated based on the electron mobility of a material used in the electron transport layer and the film thickness of the electron transport layer. In this case, the film thickness of the electron transport layer may be several 10 nm in order to optimize the balance between holes and electrons in the emitting layer. Accordingly, in order to improve the response time of the OLED element, the electron mobility of the electron transport layer may be improved. Since an inorganic material has higher electron mobility than an organic material, the response time of an OLED element using an inorganic material in the electron transport layer is faster than that of an OLED element using an organic material in the electron transport layer.

In addition, the OLED element may be manufactured by a vapor deposition method. Forming only the electron transport layer by another manufacturing method may increase costs. Examples of the vapor deposition method include deposition of heating a resistant wire and electron beam deposition. Examples of the inorganic material which can be used to form a film by these vapor deposition methods include semiconductor materials of periodic table Groups II-VI. In particular, a compound of zinc (Zn) and sulfur (S) enhances reproducibility of the film thickness. The use of the inorganic material on the electron transport layer prevents the OLED element from deteriorating due to oxygen or moisture, thereby using the OLED element for a long time.

### Example 1

An exemplary advantage of the invention will be described based on a specific example.

A glass substrate, which has dimensions of 32 mm x 25mm x 1 mm, provided with transparent electrodes made of indium tin oxide (ITO) was cleaned in isopropyl alcohol for 5 minutes by ultrasonic cleaning, and then cleaned for 5 minutes by UV ozone cleaning. After the cleaning, the glass substrate was fixed to a substrate holder, and an organic layer and a cathode are formed with a deposition apparatus for heating a resistant wire.

The organic layer and the cathode include a hole transport layer formed of 4-4'bis[*N*-(1-naphthyl)-*N*-phenyl-amino]biphenyl (α-NPD) and having a thickness of 50 nm, an emitting layer formed of 0.5 mass% 5,6,11,12-tetraphenyltetracen (rubrene) doped tris(8-hydroxyquinoline)aluminum (Alq₃) and having a thickness of20nm, an electron transport layer formed of ZnS and having a thickness of 50 nm, an electron injection layer formed of LiF and having a thickness of 0.4 nm, and a cathode formed of Al and having a thickness of 150 nm.

A response time of the manufactured OLED element was evaluated. The frequency (cutoff frequency) at which the output light intensity upon applying a sinusoidal voltage of a 5 V amplitude and a 5 V bias voltage for varying a frequency is halved was measured. The measurement result is shown in FIG. 2.

As shown in FIG. 2, a cutoff frequency of the OLED element in Example 1 was 20 MHz.

### Comparative Example 1

In Comparative Example 1, the OLED element, which was manufactured in the same manner as that in Example 1 except that an Alq₃ layer (thickness of 50 nm) was used instead of ZnS in the electron transport layer, was used to evaluate a response time of the OLED element. The cutoff frequency of the OLED element upon applying a sinusoidal voltage of a 5 V amplitude and a 5 V bias voltage was 5 MHz.

Comparing the result of Example 1 with the result of Comparative Example 1, it was found that the response time of the OLED element of Example 1, in which ZnS is used in the electron transport layer, was considerably improved.

FIG. 2 is a graph showing frequency dependency of the output light intensity of the respective OLED elements in Example 1 and Comparative Example 1. As shown in FIG. 2, it was proven that the OLED element in Example 1 could obtain the output light intensity to some extent even though its frequency is high, compared with the OLED element in Comparative Example 1.

### Examples 2 to 8 and Comparative Examples 2 and 3

Varying the film thickness of ZnS as in Table 1, OLED elements in Examples 2 to 8 and Comparative Examples 2 and 3 were manufactured to measure respective cutoff frequencies. At this time, the amplitude of a sinusoidal voltage was set to 5 V and a bias voltage thereof is set to 5 V. The measurement results in addition to the results of Example 1 are shown in Table 1.

**Table 1**

| | FILM THICKNESS (nm) OF ZnS (ELECTRON TRANSPORT LAYER) | CUTOFF FREQUENCY (MHz) | BRIGHTNESS (cd/m²) UPON APPLYING CURRENT OF 1 A/cm² |
|---|---|---|---|
| COMPARATIVE EXAMPLE 2 | 5 | broken | broken |
| EXAMPLE 2 | 10 | 10 | 3000 |
| EXAMPLE 3 | 25 | 15 | 4000 |
| EXAMPLE 1 | 50 | 20 | 5000 |
| EXAMPLE 4 | 75 | 20 | 6400 |
| EXAMPLE 5 | 100 | 20 | 6000 |
| EXAMPLE 6 | 150 | 18 | 7000 |
| EXAMPLE 7 | 200 | 19 | 4500 |
| EXAMPLE 8 | 300 | 15 | 5200 |
| COMPARATIVE EXAMPLE 3 | 400 | No emission | No emission |

As shown in Table 1, emission could not be observed in the OLED element (Comparative Example 3) in which the film thickness of ZnS was more than 300 nm. The reason is thought to be that electron movement from the cathode to the emitting layer is difficult since the film thickness of ZnS is thick. In addition, emission could not be observed in the OLED element (Comparative Example 2) in which the film thickness of ZnS was 5 nm since the OLED element was broken upon applying the voltage. It is thought that the OLED element is broken since a large amount of carrier (hole or electron) flows and the electron transport layer is thin.

By contrast, in the OLED elements (Examples 1 to 8), in which the film thickness of ZnS is in the range from 10 nm to 300 nm, normal emission was possible and the cutoff frequency was improved, compared to the OLED element in Comparative Example 1. Consequently, it was confirmed that the response time can be improved by inserting ZnS.

In addition, the response characteristic or luminous efficiency can be further improved by adding a reducing dopant to the electron transport layer. In particular, an improvement in the response characteristic and the luminous efficiency can be realized by using a material of which a work function is 2.9 eV or less. Here, a reducing dopant denotes a substance which can reduce an electron transport material (electron transporting compound). Accordingly, a substance which has a certain reducing property can be used. For example, at least one substance selected from a group consisting of alkali metals, alkaline earth metals, rare earth metals, alkali metal oxides, alkali metal halides, alkaline earth metal oxides, alkaline earth metal halides, rare earth metal oxides, and rare earth metal halides can be appropriately used. As a reducing dopant, at least one alkali metal selected form the group consisting of Na (work function: 2.4 eV), K (work function: 2.3 eV), Rb (work function: 2.2 eV), and Cs (work function: 2.0 eV) can be used. Alternatively, at least one alkali earth metal selected from the group consisting of Ca (work function: 2.9 eV), Sr (work function: 2.5 eV), and Ba (work function: 2.5 eV) can also be used. The luminous efficiency or the response time is improved by using a material of which the work function is 2.9 eV or less as the dopant of the electron transport layer. Among these materials, a reducing dopant may be at least one alkali metal selected from the group consisting of K, Rb, and Cs. Such alkali metals particularly have a high reducing capability and improvement in emission brightness or long lifetime of the OLED element can be realized just by adding a relatively small quantity to the electron injection layer. In addition, as a reducing dopant of which the work function is 2.9 eV or less, a combination of two or more kinds of alkali metals , for example, a combination containing Cs; a combination of Cs and Na; Cs and K; Cs and Rb; or a combination of Cs, Na, and K may be used. The reducing capability can be efficiently improved by combining Cs and the response characteristic and luminous efficiency of the OLED element can be improved by doping to the electron transport layer.

### Examples 9 and 10

A glass substrate, which has dimensions of 32 mm x 25mm x 1 mm, provided with transparent electrodes made of indium tin oxide (ITO) was cleaned in isopropyl alcohol for 5 minutes by ultrasonic cleaning, and then cleaned for 5 minutes by UV ozone cleaning. After the cleaning, the glass substrate was fixed to a substrate holder and an organic layer and a cathode are formed with a deposition apparatus for heating a resistant wire.

The organic layer and the cathode include a hole transport layer formed of α-NPD and having a thickness of 50 nm, an emitting layer formed of 0.5 mass% rubrence-doped Alq₃ having a thickness of 20 nm, an electron transport layer formed of ZnS doped with alkali metals of 10 mass% and having a thickness of 50 nm, an electron injection layer formed of LiF and having a thickness of 0.4 nm, and a cathode formed of Al and having a thickness of 150 nm. In this case, as alkali metals, LiF (Example 9) and CsF (Example 10) were used.

A response time of the manufactured OLED element was evaluated. A frequency (cutoff frequency) at which an output light intensity at a time of applying a sinusoidal voltage of a 5 V amplitude and a 5 V bias voltage for varying a frequency is halved was measured. The cutoff frequency of both the OLED elements was 25 MHz. Consequently, an improvement in the response time could be realized by using ZnS doping the alkali metal to the electron transport layer.

### Examples 11 through 16

OLED elements of examples 11 through 16 were manufactured similar to the OLED elements of examples 9 and 10 except for a doped alkali metal in the electron transport layer. In examples 11 through 16, Na, K, Nb, Cs, Sr and Ba were respectively used as the doped alkali metal. In example 11, Na was used as the alkali metal. In example 12, K was used. In example 13, Nb was used. In example 14, Cs was used. In example 15, Sr was used. In example 16, Ba was used.

Response times of the manufactured OLED elements were evaluated by measuring the cutoff frequencies of the OLED elements of examples 11 through 16 in the same manner as examples 1 through 10. The measurement results are shown in Table 2.

**Table 2**

| | ALKALI METAL | CUTOFF FREQUENCY (MHz) |
|---|---|---|
| EXAMPLE 1 | -- | 20 |
| EXAMPLE 11 | Na | 24 |
| EXAMPLE 12 | K | 22 |
| EXAMPLE 13 | Nb | 25 |
| EXAMPLE 14 | Cs | 26 |
| EXAMPLE 15 | Sr | 24 |
| EXAMPLE 16 | Ba | 28 |

As shown in Table 2, the cutoff frequencies of the OLED elements of the embodiments 11 through 16 were in the range of 22 MHz to 28 MHz, which is greater than the cutoff frequency of the OLED element of the embodiment 1. Therefore, the response time of the OLED element can be improved by using ZnS doping an alkali metal such as Na, K, Nb, Cs, Sr, and Ba to the electron transport layer.

While exemplary embodiments of the invention have been described and illustrated above, it should be understood that these are exemplary of the invention are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

## Claims

1. An organic light-emitting diode element, comprising:
an anode;
an emitting layer;
an electron transport layer; and
a cathode,
wherein the electron transport layer comprises a semiconductor material.

2. The organic light-emitting diode element according to claim 1, wherein the semiconductor material of the electron transport layer is a compound semiconductor comprising at least one element of periodic table Groups II-VI.

3. The organic light-emitting diode element according to claim 2, wherein the compound semiconductor is ZnS.

4. The organic light-emitting diode element according to claim 3, wherein a thickness of the electron transport layer is in a range of about 10 nm to 300 nm.

5. The organic light-emitting diode element according to any one of claims 1 to 4, wherein the semiconductor material of in the electron transport layer comprises a reducing dopant.

6. The organic light-emitting diode element according to claim 5, wherein the reducing dopant has a work function of about 2.9 eV or less.

7. The organic light-emitting diode element according to claim 6, wherein the reducing dopant is at least one dopant selected from a group consisting of alkali metals, alkali earth metals, rare earth metals, alkali metal oxides, alkali metal halides, alkali earth metal oxides, alkali earth metal halides, oxides of rare earth element, and rare earth metal halides.

8. An optical interconnection module comprising a light source for transmission comprising the organic light-emitting diode element according to any one of claims 1 to 7.

9. The organic light-emitting diode element according to claim 5, wherein the reducing dopant comprises at least one of the alkali metals K, Rb, and Cs.

10. The organic light-emitting diode element according to claim 5, wherein the reducing dopant comprises a combination of Cs and Na.

11. The organic light-emitting diode element according to claim 5, wherein the reducing dopant comprises a combination of Cs and K.

12. The organic light-emitting diode element according to claim 5, wherein the reducing dopant comprises a combination of Cs and Rb.

13. The organic light-emitting diode element according to claim 1, wherein the emitting layer comprises two or more organic materials.
